# EUROPÄISCHE PATENTSCHRIFT

(11) **EP 2 345 317 B1**
(45) Veröffentlichungstag und Bekanntmachung des Hinweises auf die Patenterteilung: **06.02.2013**
(21) Anmeldenummer: 09767939.3
(22) Anmeldetag: 09.11.2009
(51) Int. Cl.: H05K 7/20

(54) **VERFAHREN ZUR KÜHLLUFTREGELUNG IN GERÄTESCHRÄNKEN UND GERÄTESCHRANK MIT EINER SENSOR-ANORDNUNG**
METHOD FOR COOLING-AIR REGULATION IN EQUIPMENT CABINETS AND EQUIPMENT CABINET WITH A SENSOR ARRANGEMENT
PROCÉDÉ DE RÉGULATION DE L'AIR DE REFROIDISSEMENT DANS LES ARMOIRES ÉLECTRIQUES ET ARMOIRE ÉLECTRIQUE

(30) Priorität: 14.11.2008 WO PCT/EP2008/009670
(43) Veröffentlichungstag der Anmeldung: 20.07.2011
(73) Patentinhaber: Knürr GmbH, 94424 Arnstorf (DE)
(72) Erfinder: EBERMANN, Heiko, 01109 Dresden (DE); KOCH, Peter, 86946 Issing (DE); REITER, Rupert, 84378 Dietersburg (DE); TREPTE, Wolfgang, 01665 Zehren (DE)
(74) Vertreter: Heim, Hans-Karl
(86) Internationale Anmeldenummer: PCT/EP2009/007995
(87) Internationale Veröffentlichungsnummer: WO 2010/054786

(56) Entgegenhaltungen:
- EP-A1- 1 614 333
- WO-A2-2007/019304
- US-A1- 2003 053 293
- US-A1- 2003 147 216
- US-A1- 2009 034 187

## Beschreibung

Die Erfindung betrifft ein Verfahren zur Kühlluftregefung in Geräteschränken, insbesondere in Rechnerräumen, gemäß dem Oberbegriff des Anspruchs 1 und eine Sensor-Anordnung zur Kühltuftregelung in Geräteschränken von Rechnerräumen gemäß dem Oberbegriff des Anspruchs 9.

Die Erfindung ist insbesondere für Serverschränke von Serverräumen beziehungsweise Rechenzentren, in welchen eine Vielzahl von Schränken angeordnet sind, geeignet.

Die steigenden Leistungen der Prozessrechner und Server ist mit einer stetig steigenden Wärmelast in den Rechenzentren verbunden. Die elektronischen Moduleinheiten beziehungsweise Bauelemente, insbesondere Hochleistungsprozessoren und Server in einer kompakten Bauform, erreichen erhebliche Verlustleistungen, welche abgeführt werden müssen. Die Förderung des zur Kühlung der elektronischen Moduleinheiten benötigten Luftstroms verbraucht einen erheblichen Teil der elektrischen Energie, welche zum Betrieb des Gesamtsystems erforderlich ist. Die elektrische Leistungsaufnahme der Ventilatoren steigt proportional zur dritten Potenz des geforderten Volumenstroms an. Ein hoher Volumenstrom ist deshalb mit einem sehr hohen Stromverbrauch verbunden.

Um in Geräteschränken, beispielsweise Serverschränken von Rechenzentren, die umzuwälzende Luftmenge in jedem Betriebszustand so klein wie möglich zu halten, ist es bekannt, eine strikte Abtrennung der Kalt- beziehungsweise Kühlluft von der mit der Verlustwärme der elektronischen Moduleinheiten beladenen Warmluft beziehungsweise Abluft zu realisieren. Die strikte Abtrennung der den elektronischen Moduleinheiten in einem Schrank zuzuführenden Kühlluft von der abzuführenden, erwärmten Abluft verhindert eine Vermischung der Kühl- und Abluft und dadurch einen erhöhten Luftbedarf zur Abführung der Verlustwärme. Mischluft verringert die Temperaturdifferenz der Luft, die für den Stoff-Wärmetransport zur Verfügung steht und reduziert damit die transportierte Wärmemenge pro Volumeneinheit.

Für eine energieeffiziente Kühlung von elektronischen Moduleinheiten, insbesondere Servern, in Geräteschränken ist es bekannt, drehzahlregulierte Ventilatoren für einen geschlossenen Kühlluftkreislauf zu verwenden (EP 1 614 333 B1).

Aus der Klimatechnik sind Verfahren bekannt, bei welchen die Druckdifferenz zwischen einer Warm- und Kaltseite als Führungsgröße einer Regelung für einen Luftvolumenstrom mittels variabler Ventilatordrehzahlen genutzt wird. Diese Verfahren sind aber relativ kostenaufwendig und insbesondere bei höheren Strömungsgeschwindigkeiten und turbulenten Strömungen relativ ungenau.

Aus US 2003/0147216 A1 ist ein Verfahren zur Kühlluftregelung in einem Geräteschrank oder in einer Reihe von Geräteschränken bekannt, bei welchem in wenigstens einem Wärmetauscher gekühlte und einem Kaltluftkanal mit Hilfe von Gebläsen zugeführte Kaltluft über düsenförmige Wandöffnungen in den Aufnahmeraum für elektrische Bauelemente gelangt, über die Bauelemente geführt wird und mit der Verlustwärme beaufschlagt durch Wandöffnungen oder -düsen in einen Abluftkanal gelangt und danach dem Wärmetauscher zur Entwärmung wieder zugeführt wird. Temperatursensoren sind wie die elektronischen Bauelemente und ein Regler auf Trägerboards montiert und ermöglichen eine Regelung der Gebläse und/oder der seitlichen Luftdüsen und/oder eines Ventils für ein Kältemittel, welches den Wärmetauscher zur Abführung der Verlustwärme nach außen zugeleitet wird.

Aus WO 2007/019304 A2 ist ein Verfahren zur Anpassung der einem Rack aus der Umgebung zugeführten Kaltluft an die Kaltluftzuführungen der mit Lüftern versehenen, einzelnen Geräte im Aufnahmeraum eines Racks sowie zur Anpassung der Warmluftabführung aus dem Rack an die Umgebung an die Abluft aus den einzelnen Geräten bekannt. Um Druckdifferenzen zwischen der Umgebungsluft und dem Luftzutrittsbereich beziehungsweise Luftaustrittsbereich in dem Rack zu vermeiden, ist eine Regelung des Ventilators für die Luftzuführung zu dem Rack und des Ventilators für die Luftabführung aus dem Rack mittels Temperatursensoren vorgesehen, welche in einer Luftpassage zwischen dem Abluftbereich des Racks und der Rackumgebung angeordnet sind.

Der Erfindung liegt die Aufgabe zugrunde, ein Verfahren zur Kühlluftregelung in Geräteschränken sowie einen Geräteschrank mit einer Sensoranordnung, insbesondere von Rechnerräumen, zu schaffen, welche eine möglichst genaue Regelung einer möglichst geringen, umzuwälzenden Luftmenge und dadurch eine erhebliche Energieeinsparung gewährleistet.

In Bezug auf das Verfahren wird die Aufgabe durch die Merkmale des Anspruchs 1 und in Bezug auf den Geräteschrank durch die Merkmale des Anspruchs 9 gelöst. Zweckmäßige Ausgestaltungen sind in den Unteransprüchen und in der Figurenbeschreibung enthalten.

Ein Grundgedanke des erfindungsgemäßen Regelungskonzeptes für luftgekühlte Schränke in Rechenzentren kann darin gesehen werden, die Ventilatoren derart zu steuern, dass den elektronischen Moduleinheiten, beispielsweise Servern, in deren Ansaugbereich genau die erforderliche Kühlluftmenge zur Verfügung gestellt wird. Wenn die Luftmenge zu gering ist, ist die erforderliche Abführung der Verlustwärme der Server nicht gewährleistet, und es kommt zu einer Überhitzung. Wenn die Luftmenge zu groß ist, wird zu viel Energie verbraucht, was sowohl im Hinblick auf die Betriebskosten als auch für die Umwelt nachteilig ist.

Bei dem erfindungsgemäßen Verfahren und dem Geräteschrank wird der erforderliche, geförderte Luftvolumenstrom zur Kühlung eines Schrankes an den Kühltuftvolumenstrom der elektronischen Moduleinheiten, bei denen es sich vorrangig um Server handelt, angepasst. Dabei ist der für die Server erforderliche Volumenstrom wesentlich durch die Konstruktion der Server vorgegeben.

Bei einem Verfahren zur Kühlluftregelung in Geräteschränken, insbesondere von Rechnerräumen, bei welchem den in den Geräteschränken angeordneten elektronischen Moduleinheiten, beispielsweise Servern, Kühlluft in einem geschlossenen Kühlluftkreislauf zugeführt und die mit der Verlustwärme der Server beaufschlagte Abluft in einem Luft-Fluid-Wärmetauscher abgekühlt wird, wobei die Verlustwärme von einem Kühlfluid aufgenommen und außerhalb des Rechnerraums abgegeben wird und die erforderliche Kühlluftmenge des geschlossenen Kühlluftkreislaufes über die Drehzahlregelung von Ventilatoren in Abhängigkeit von der Temperatur der Kühlluft gefördert wird, ist erfindungsgemäß vorgesehen, die erforderliche Kühlluftmenge dem von Lüftern der elektronischen Moduleinheiten geförderten Volumenstrom anzupassen und die Temperatur der den Servern zugeführten Kühlluft in einem Leckluftstrom zu messen.

Erfindungsgemäß wird der Leckluftstrom zwischen dem Kühlluftbereich, beispielsweise einem Kühlluftkanal eines Geräteschrankes oder einer Schrankanordnung mit wenigstens einem Geräteschrank und einer Kühleinheit, bei welcher ein Kaltluftkanal bevorzugt in der Kühleinheit ausgebildet ist, und dem Abluftbereich, beispielsweise einem Abluftkanal des Geräteschrankes bzw. einem Warmluftkanal einer Kühleinheit, welche insbesondere seitlich angrenzend an einem Geräteschrank oder zwischen zwei Geräteschränken angeordnet ist, ausgebildet, und die Temperatur des Leckluftstromes gemessen und als Führungsgröße für die Drehzahlregelung der Ventilatoren benutzt.

Das Regelungskonzept beziehungsweise Messprinzip besteht in der Temperaturmessung von wenigstens einem Leckluftstrom zwischen dem Kalt- und Warmbereich eines Schrankes, wobei die gemessene Temperatur für die Regelung der Ventilatoren für den Kühlluftstromkreis benutzt wird.

Erfindungsgemäß wird zur Ausbildung eines Leckluftstroms in einem Schrank oder in einer Schrankanordnung mit wenigstens einem Geräteschrank und einer Kühleinheit gezielt eine Öffnung in die Lufttrennung, beispielsweise in eine Lufttrennwand. welche den Kühlluftkanal vom Abluftbereich abschottet, eingebracht. In oder auch durch diese Öffnung wird ein Temperatursensor eingesetzt, über welchen die Ventilatoren, welche beispielsweise in einem rückseitigen Abluftkanal eines Geräteschrankes oder als Ventilatormodule in einer Kühleinheit einer Schrankordnung angeordnet sind, geregelt werden.

Gemäß dem zugrunde liegenden Messprinzip wird die Temperatur T_{L} des Leckluftstroms von dem geförderten Luftvolumen und der Strömungsrichtung bestimmt beziehungsweise beeinflusst. Wenn zu wenig Luft gefördert wird, saugen die Lüfter der elektronischen Moduleinheiten beziehungsweise Server von dem warmen Abluftbereich Luft in den Kühlluftkanal, was zu einer Temperaturerhöhung führt und bewirkt, dass die Drehzahlen der Ventilatoren im Abluftbereich erhöht werden. Die Führungsgröße für die Drehzahlregelung der Ventilatoren ist die Temperatur T_{L} des Leckluftstroms, welche von der Strömungsrichtung und damit von dem zur Verfügung gestellten Luftvolumenstrom im Kühlluftkanal bestimmt wird. Durch die Regelung der Ventilatordrehzahlen wird der Volumenstrom der Kühlluft an den von den Servern tatsächlich benötigten Volumenstrom angepasst.

Das erfindungsgemäße Verfahren kann vorteilhaft bei einem Geräteschrank, welcher in EP 1 614 333 B1 beschrieben ist, angewendet werden. Bei einem derartigen Geräteschrank kann ein Leckluftstrom zweckmäßigerweise durch eine Öffnung in einer Trennwand im Bereich des Kühlluftkanals ausgebildet und mit einem Temperatursensor versehen werden.

Bei einer Schrankanordnung mit Geräteschränken, welche insbesondere reihenartig angeordnet sind, und bei welcher eine Kühleinheit mit einem Wärmetauscher und Ventilatoren seitlich angrenzend an einen Geräteschrank oder zwischen zwei Geräteschränken angeordnet ist, wobei die Ventilatoren in Ventilatormodulen aufgenommen sind und in der Kühleinheit frontseitig ein Kaltluftkanal für die im Wärmetauscher abgekühlte und mittels der Ventilatormodule gerichtet austretenden Kaltluft und rückseitig ein Warmluftkanal für die mit der Verlustwärme beaufschlagte Warmluft aus einem oder zwei Geräteschränken ausgebildet sind, kann das erfindungsgemäße Verfahren ebenfalls vorteilhaft angewendet werden. Dabei kann wenigstens ein Leckluftstrom mit Hilfe einer Öffnung in einer Trennwand zwischen dem Kaltluftkanal und dem Warmluftkanal ausgebildet und mit einem Temperatursensor versehen sein. Eine besonders vorteilhafte Regelung wird erreicht, wenn pro Ventilatormodul ein Leckluftstrom vorgesehen ist. Zur Anordnung von Geräteschränken und wenigstens einer Kühleinheit, welche einen Wärmetauscher und Ventilatoren in einschiebbaren Ventilatormodulen aufweist, wird Bezug genommen auf die deutsche Patentanmeldung Nr. 10 2007 061 966.0 und die parallele internationale Patentanmeldung PCT/EP 2008/008908.

Die Positionierung der gezielt eingebrachten Öffnung für den Leckluftstrom erfolgt oberhalb des obersten Servers, wobei die Öffnung zweckmäßigerweise derart dimensioniert wird, dass sie so klein wie möglich aber gleichzeitig groß genug ist, damit sich oberhalb des obersten Servers keine Luftmenge stauen, insbesondere kein Warmluftsee bilden kann.

Grundsätzlich ist der Durchmesser der Öffnung von der Größe des Schrankes und der darin angeordneten und betriebenen Moduleinheit abhängig.

Es wurde gefunden, dass der Durchmesser der Öffnung für einen Leckluftstrom in einem Bereich von etwa 5 bis 15 mm liegen und beispielsweise 8, 9, 10, 11, 12, 13 mm beragen kann. Im Übrigen kann der Durchmesser durch wenige Versuche ermittelt werden, und es ist auch möglich, den Durchmesser vor Ort, entsprechend der Regelung eines Schrankes und der entwickelten Wärme zu verändern, beispielsweise unterschiedliche Schläuche, Rohre oder für eine regulierbare Öffnung Steck- oder Schiebeelemente zur Durchmesseränderung vorzusehen.

Bei dem erfindungsgemäßen Regelungskonzept für einen Geräteschrank ist es vorteilhaft, dass gleichzeitig noch die Kühllufteintrittstemperatur in dem insbesondere frontseitig angeordneten Kühlluftkanal über den Wasserdurchfluss des Wärmetauschers geregelt werden kann.

Es kann sich außerdem als zweckmäßig erweisen, dass ein zweiter Temperatursensor im bodenseitigen Bereich des Kühlluftkanals und nahe dem luft-Fluid-Wärmetauscher auch die Zulauftemperatur des Kühlfluids des Luft-Fluid-Wärmetauschers regelt.

Grundsätzlich kann die Durchflussmengenregelung und/oder Regelung der Zulauftemperatur des Kühlfluids auch mit Hilfe des Temperatursensors im Leckluftstrom erfolgen. Bei Anordnung eines Temperatursensors im Leckluftstrom im oberen Bereich des Geräteschrankes beziehungsweise des Kühlluftkanals und eines zweiten Temperatursensors im bodenseitigen Bereich nahe dem Wärmetauscher ist es zweckmäßig, eine gegenseitige Beeinflussung der Regelkreise zu vermeiden und zu berücksichtigen, dass nach Austritt aus dem Wärmetauscher sich die Kühlluft geringfügig erwärmt. Es ist deshalb zweckmäßig, den Temperatursollwert des Sensors im Leckluftstrom für die Regelung der Ventilatoren im Abluftbereich höher als den Sollwert am zweiten Temperatursensor einzustellen.

Vorteilhafterweise kann der Leckluftstrom für einen darin angeordneten Temperatursensor auch mit Hilfe eines Rohres oder eines Schlauches gebildet werden. Das Rohr beziehungsweise der Schlauch müssen dann zwischen dem Kühlluftkanal und dem Abluftbereich beziehungsweise -kanal verlegt werden. Das Rohr beziehungsweise der Schlauch kann vorteilhaft in unterschiedlichen Lagevarianten verlegt werden, und die Leckluft kann dann aus bevorzugten Schrankbereichen entnommen und die Temperatur dieser Leckluft gemessen und das entsprechende Signal zur Regelung der Ventilatoren benutzt werden.

Es kann sich auch als zweckmäßig erweisen, in einem Geräteschrank mehr als einen Leckluftstrom auszubilden und jeweils einen Temperatursensor in die Öffnung und/oder in ein Rohr und/oder in einen Schlauch für den jeweiligen Leckluftstrom anzuordnen. Die Anordnung von Temperatursensoren in mehreren Leckluftströmen kann zudem vorteilhaft zur individuellen Regelung einzelner Ventilatoren bzw. Lüfter benutzt werden.

Bei der Positionierung kann die Belegung mit elektronischen Moduleinheiten beziehungsweise Servern mit besonders hoher Verlustwärme berücksichtigt werden, was sich vorteilhaft auf die Energiebilanz der Kühlung der gesamten Anordnung auswirkt.

Die Vorteile des erfindungsgemäßen Regelungsverfahrens und des Geräteschrankes mit der Sensor-Anordnung bestehen in einer erheblichen Energieeinsparung aufgrund einer weitgehend angepassten erforderlichen Luftmenge in einem Schrank beziehungsweise Rechenzentrum. Der Einsatz von Kühlluft kann gesenkt werden und der Raum in einem Rechenzentrum beziehungsweise Serverraum kann optimal ausgenutzt werden. Neben den geringeren Energiekosten für den Antrieb der Ventilatoren wird die passende Zulufttemperatur für die Server sichergestellt. Insgesamt kann eine besonders energieeffiziente Kühlung erreicht werden.

Die Erfindung wird nachstehend anhand einer Zeichnung weiter erläutert: In dieser zeigen in einer stark schematisierten Darstellung
- Fig. 1: einen Längsschnitt durch einen erfindungsgemäßen Geräteschrank mit der Sensoranordnung;
- Fig. 2: einen Längsschnitt durch den Schrank gemäß Fig. 1 mit einer alternativen Sensoranordnung;
- Fig. 3: eine vergrößerte Ansicht gemäß Pfeil III in Fig. 1 und
- Fig. 4: einen Längsschnitt gemäß Linie IV-IV in Fig. 3.

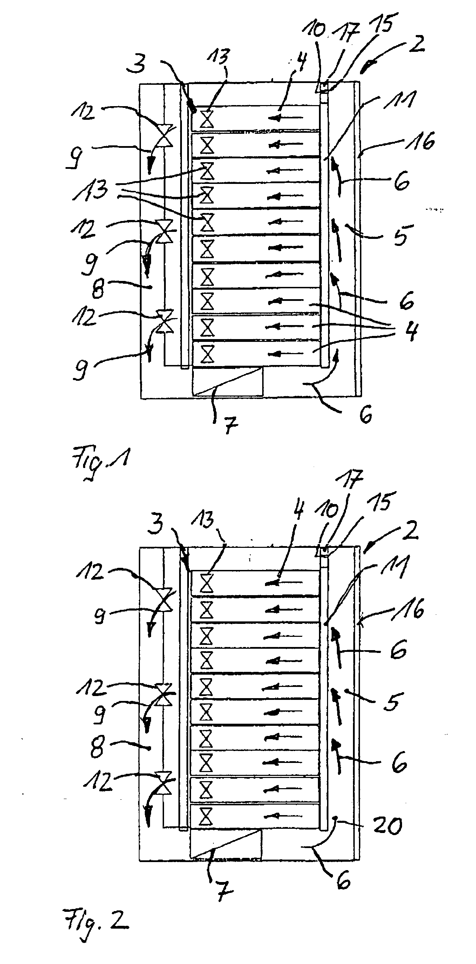

Fig. 1 zeigt einen Geräteschrank 2 mit einem Aufnahmeraum 3 und übereinander angeordneten, elektronischen Moduleinheiten 4. Der Geräteschrank 2 ist in diesem Ausführungsbeispiel ein Serverschrank, und die elektronischen Moduleinheiten 4 können z.B. Hochleistungsserver von einer Höheneinheit sein. Die Luftführung im Bereich der Server 4 wird durch Pfeile verdeutlicht. Innerhalb der Gehäuse der Server 4 ist jeweils ein Lüfter 13 angeordnet, welcher die Luftführung durch die Server 13 bewerkstelligt und Kühlluft 6 über frontseitige Lufteintrittsöffnungen (nicht dargestellt) ansaugt, über die Verlustwärme erzeugenden, elektronischen Bauteile (nicht dargestellt) führt und über rückseitige Luftaustrittsöffnungen (nicht dargestellt) einem Abluftkanal 8 zuführt.

Unterhalb des Aufnahmeraums 3 ist ein Luft-Fluid-Wärmetauscher 7 angeordnet, welcher hier ein Luft-Wasser-Wärmetauscher ist und an die Kaltwasserversorgung des Gebäudes angeschlossen ist.

Die im Luft-Fluid-Wärmetauscher 7 abgekühlte Luft wird als Kühlluft 6 einem Kühlluftkanal 5 zugeführt, welcher frontseitig angeordnet ist, über nahezu die gesamte Höhe des Geräteschankes 2 reicht und mit den Lufteintrittsöffnungen (nicht dargestellt) der Server 4 in Verbindung steht. Die von den Servern 4 erwärmten Abluft 9, wird über einen rückseitigen Abluftkanal 8 mit Hilfe von Ventilatoren 12 in diesem Abluftkanal 8 in den Wärmetauscher 7 gefördert.

Die lufttechnische Trennung der zugeführten Kühlluft 6 von der erwärmten Abluft 9 erfolgt im frontseitigen Bereich des Aufnahmeraums mit Hilfe von Trennwänden 11, welche beispielsweise abgewinkelte Bleche sein können und vertikal angeordnet sind, so dass die Trennwände 11, eine Fronttür 16 und die Gehäusefrontseiten der Server 4 den Kühlluftkanal 5 zusammen mit oberen und unteren Abdeckungen des Schranks 2 begrenzen.

Zur Regelung des geschlossenen Kühlluftkreislaufes im Geräteschrank 2 gemäß Fig. 1 und Anpassung der notwendigen umzuwälzenden Kühlluftmenge an den von den Lüftern 13 der einzelnen Server 4 geförderten Volumenstrom wird die Temperatur der Kühlluft, welche den Servern 4 zugeführt wird, in einem Leckluftstrom gemessen. Der Leckluftstrom ist im Ausführungsbeispiel gemäß Fig. 1 im Bereich einer oberen Trennwand 17 oberhalb des obersten Servers 4 ausgebildet und verbindet den Kühlluftkanal 5 mit dem Abluftkanal 8 beziehungsweise dem Abluftbereich jenseits des Kühlluftkanals 5.

Der Leckluftstrom, welcher gezielt dimensioniert wird, wird in Fig. 1 durch eine Öffnung 15 in der oberen Trennwand 17 gebildet, wobei die Öffnung 15 derart dimensioniert ist, dass sie relativ klein, aber gleichzeitig groß genug ist, damit sich kein Warmluftsee im oberen Bereich des Kühlluftkanals 5 bilden kann.

Ein Warmluftsee im oberen Bereich des Kühlluftkanals 5 beziehungsweise eine Warmluftschicht kann entstehen, wenn die von den Servern 4 oder anderen Bauelementen im Aufnahmeraum 3 entwickelte Verlustwärme besonders groß ist und über die Metallgehäuse an die Kühlluft im Kühlluftkanal 5 übertragen wird. Um zu verhindern, dass der Warmluftsee bis in den Bereich der Server 4 reicht, ist die Öffnung 15 für einen Leckluftstrom entsprechend dimensioniert, so dass der Warmluftsee im oberen Bereich in den Abluftkanal 8 abgeführt und nicht von den Lüftern 13 der Server 4 angesaugt werden kann.

Wesentlich ist eine strikte Trennung des Kaltluftbereichs beziehungsweise des Kühlluftkanals 5 von dem Abluftbereich beziehungsweise Abluftkanal 8 durch die Trennwände 11 beidseitig der Serverfrontseiten und durch Trennelemente, beispielsweise Blindplatten (nicht dargestellt), an frei bleibenden Positionen zwischen den über- und/oder nebeneinander angeordneten Servern 4. In den Blindplatten kann erforderlichenfalls ebenfalls ein zu detektierender Leckluftstrom zur Kühlluftregelung ausgebildet werden.

Um den Servern 4 eine Luftmenge zur Verfügung zu stellen, welche der benötigten Kühlluftmenge der Server 4 entspricht beziehungsweise auf die Leistung der Lüfter 13 der Server 4 abgestimmt ist, wird der Leckluftstrom im Bereich der Öffnung 15 detektiert, indem ein Temperatursensor 10 angeordnet und zur Regelung der Ventilatoren 12 im rückseitigen Abluftkanal 8 verwendet wird. Der Temperatursensor 10 kann in die Öffnung 15 eingesetzt werden, so dass mittels der Temperaturmessung festgestellt werden kann, ob zu viel Luft oder zu wenig Luft in den Kühlluftkanal 5 gefördert und für die Server 4 zur Verfügung gestellt wird. Wenn zu wenig Luft gefördert wird, saugen die Lüfter 13 der Server 4 von dem Abluftbereich beziehungsweise Abluftkanal 8 die erwärmte Abluft 9 in den Kühlluftkanal 5, so dass sich die Drehzahl der Ventilatoren 12 im Abluftkanal 8 erhöht und umgekehrt.

An Stelle einer Öffnung 15 kann auch ein Rohr oder ein Schlauch (nicht dargestellt) im Bereich der Lufttrennung beziehungsweise der Trennwände 11 oder Blindplatten (nicht dargestellt) für einen Temperatursensor 10 eines Leckluftstroms angeordnet werden. Die Temperatur T_{L} des Leckluftstroms wird zur Drehzahlregelung der Ventilatoren 12 im Bereich des Abluftkanals 8 verwendet und bildet somit die Führungsgröße für die Drehzahlregelung der Ventilatoren 12.

Fig. 2 zeigt eine alternative Sensoranordnung mit einem Temperatursensor 10 im oberen Bereich des Geräteschrankes 2, welcher im Wesentlichen dem Geräteschrank 2 der Fig. 1 entspricht. Gleiche Merkmale sind mit identischen Bezugszeichen versehen. Ein zusätzlicher, zweiter Temperatursensor 20 ist im Kühlluftkanal 5 und nahe dem Luft-Fluid-Wärmetauscher 7 angeordnet. Der Temperatursensor 10 im Leckluftstrom dient wiederum der Regelung der Ventilatoren 12 im Bereich des Abluftkanals 8, während mit dem zweiten Temperatursensor 20 die Durchflussmenge und/oder Zulauftemperatur des Kühlfluids des Luft-Fluid-Wärmetauschers 7 geregelt werden kann.

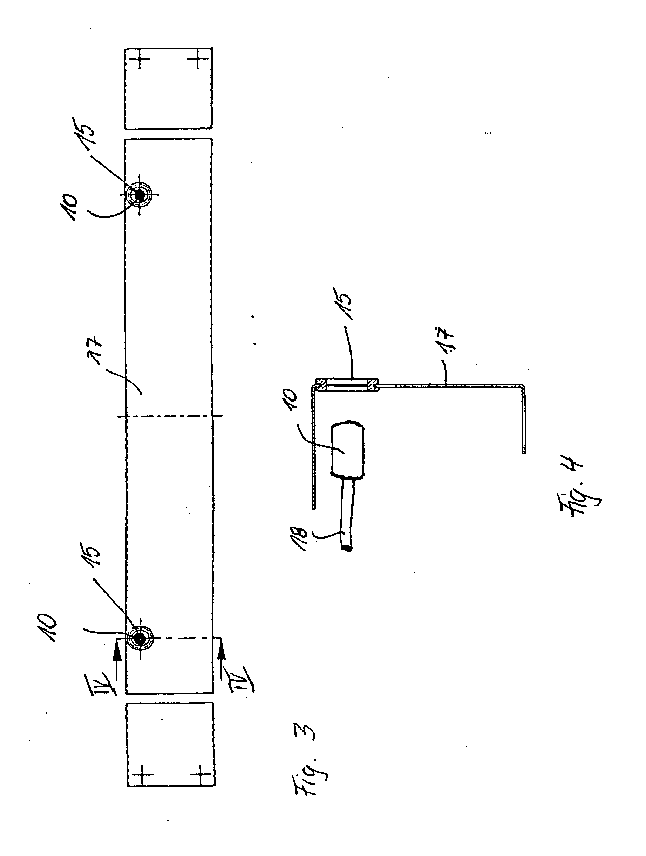

Die Figuren 3 und 4 zeigen eine obere Trennwand 17 des Kühlluftkanals 5 gemäß den Figuren 1 und 2, hier mit zwei Öffnungen 15 für jeweils einen Leckluftstrom und die Aufnahme eines Temperatursensors 10 mit Kabel 18.

In diesem Ausführungsbeispiel sind die zwei Öffnungen 15 identisch und kreisrund ausgebildet und weisen einen Durchmesser von etwa 10 mm auf.

Vorteilhaft kann der Querschnitt auch quadratisch oder rechteckig gewählt werden und der Querschnitt einer Öffnung oder die Summe der Querschnitte mehrerer Öffnungen in einem Kühlluftkanal den jeweiligen Bedingungen, wie den Schrankabmessungen, insbesondere dem Volumen des Kühlluftkanals, der Belegung des Aufnahmeraums und der Wärmeentwicklung der Moduleinheiten sowie den drehzahlgeregelten Ventilatoren angepasst werden.

## Patentansprüche

1. Verfahren zur Kühlluftregefung in Geräteschränken von Rechnerräumen,
bei welchem in den Geräteschränken (2) angeordneten elektronischen Moduleinheiten (4) Kühlluft (6) zugeführt und mit der Verlustwärme der elektronischen Moduleinheiten (4) beaufschlagte Abluft (9) in einem Luft-Fluid-Wärmetauscher (7) abgekühlt wird, wobei die Kühlluft (6) über einen frontseitig angeordneten Kühlluftkanal (5) mit Hilfe von Ventilaboren (12) in einem rückseitig angeordneten Abluftkanal (8) den elektronischen Moduleinheiten (4) über frontseitlge Öffnungen zugeführt und die erwärmte Abluft (9) über rückseitige Luftaustrittsöffnungen der elektronischen Moduleinheiten (4) dem Abluftkanal (8) und danach dem bodenseitig angeordneten luft-Fluid-Wärmetauscher (7) zugeführt wird, in welchem die Verlustwärme von einem Kühlfluid aufgenommen und außerhalb des Rechnerraumes abgegeben wird, und bei welchem zur lufttechnischen Trennung der Kühlluft (6) von der Abluft (9) Trennwände (11, 17) im Bereich des Kühlluftkanals (5) angeordnet werden und ein Leckluftstrom durch eine gezielt eingebrachte Öffnung (15) in einer oberen Trennwand (17) oberhalb der obersten elektronischen Moduleinheit (4) und zwischen dem Kühlluftkanal (5) und dem Abluftkanal (8) geführt wird und bei welchem die erforderliche Kühlluflmenge des geschlossenen Kühlluftkreislaufs über die Drehzahlregelung der Ventilatoren (12) im Abluftkanal (8)
gefördert wird,
**dadurch gekennzeichnet,**
**dass** die erforderliche Kühlluftmenge dem von Lüftern (13) in den elektronischen Moduleinheiten (4) geförderten Volumenstrom angepasst wird und dass ein Temperatursensor (10) in der gezielt eingebrachten Öffnung (15) in der oberen Trennwand (17) angeordnet und die Temperatur T_{L} des Lecktuftstroms, welche durch die Strömungsrichtung des Leckluftstroms und damit von dem zur Verfügung gestellten Luftvolumenstrom im Kühlluftkanal (5) bestimmt wird, gemessen und als Führungsgröße für die Drehzahlregelung der Ventilatoren (12) im Abluftkanal (8) verwendet wird, wobei bei einer Temperaturerhöhung des Leckluftstroms die Drehzahl der Ventilatoren (12) erhöht und bei einem Temperaturabfall die Drehzahl der Ventilatoren (12) verringert und somit der Volumenstrom der Kühlluft (6) an den von den Moduleinheiten (4) tatsächlich benötigen Volumenstrom angepasst wird.

2. Verfahren nach Anspruch 1,
**dadurch gekennzeichnet,**
**dass** die gezielt eingebrachte Öffnung (15) für einen Leckluftstrom zwischen dem Kühlluftkanal (5) und dem Abluftkanal (8) derart dimensioniert wird, dass eine oberhalb der obersten elektronischen Moduleinheit (4) im Kühlluftkanal (5) angestaute Luftmenge, insbesondere ein durch Übertragung von Verlustwärme über die Metallgehäuse an die Kühlluft im Kühlluftkanal (5) entstehender Warmluftsee, vermieden oder kontinuierlich abgeleitet wird.

3. Verfahren nach Anspruch 1 oder 2,
**dadurch gekennzeichnet,**
**dass** mit Hilfe des Temperatursensors (10) in der gezielt eingebrachten Öffnung (15) die Durchflussmenge und/oder die Zulauftemperatur des Kühlfluids des Luft-Fluid-Wärmetauschers (7) geregelt wird.

4. Verfahren nach Anspruch 1 oder 2,
**dadurch gekennzeichnet,**
**dass** mit Hilfe eines zweiten Temperatursensors (20), welcher im Kohlluftkanal (5) nahe dem Luft-Fluid-Wärmetauscher (7) angeordnet wird, die Temperatur in der Kühlluft (6) gemessen und zur Regelung der Durchflussmenge und/oder der Zulufttemperatur des Luft-Fluid-Wärmetauschers (7) verwendet wird.

5. Verfahren nach Anspruch 4,
dadurch **gekenntzeichnet**,
dass der Temperatursollwert des Temperatursensors (10) im Leckluftstrom für die Drehzahlregelung der Ventilatoren (12) im Bereich des Abluftkanals (8) höher eingestellt wird als der Temperatursollwert des zweiten Temperatursensors (20) nahe dem Luft-Fluid-Wärmetauscher (7) für die Regelung der Durchflussmenge und/oder Zulauftemperatur des Kühlfluids des Luft-Fluid-Wärmetauschers (7).

6. Verfahren nach einem der Ansprüche 1 bis 5,
dadurch **gekenntzeichnet**,
dass der Leckluftstrom in einem Rohr oder in einem Schlauch geführt wird, weicher zwischen dem Kühlluftkanal (5) und dem Abluftkanal (8) angeordnet wird.

7. Verfahren nach einem der Ansprüche 1 bis 6,
**dadurch gekennzeichnet,**
**dass** in einen Geräteschrank (2) mehr als ein Leckluftstrom ausgebildet und jeweils ein Temperatursensor in der Öffnung (15) oder in dem Rohr oder in dem Schlauch für den leckluftstrom angeordnet wird.

8. Verfahren nach einem der Ansprüche 1 bis 7,
**dadurch gekennzeichnet,**
**dass** die Leckluftströme in Abhängigkeit von der Belegung des Geräteschrankes (2) mit elektronischen Moduleinheiten (4) und deren Verlustwärme ausgebildet und mit Temperatursensoren zur Regelung der Ventilatoren (12) versehen werden.

9. Geräteschrank mit einer Sensor-Anordnung zur Kühlluftregelung in dem Geräteschrank, welcher in Rechnerräumen angeordnet ist und einen Aufnahmeraum (3) für elektronische Moduleinheiten (4), insbesondere Hochleistungsserver, einen frontseitig angeordneten Kühlluftkanal (5) zur Zuführung von Kühlluft (6) aus einem bodenseitig angeordneten Luft-Fluid-Wärmetauscher (7) zu den elektronischen Moduleinheiten (4) und einen rückseitig angeordneten Abluftkanal (8) aufweist, aus welchem die mit der Verlustwärme beaufschlagte Abluft (9) der elektronischen Moduleinheiten (4) dem Luft-Fluid-Wärmetauscher (7) zuführbar ist, wobei der Kühlluftkanal (5) lufttechnisch vom Abluftkanal (8) durch Trennwände (11, 17) getrennt ist, eine Öffnung (15) in einer oberen Trennwand (17) oberhalb der obersten elektronischen Moduleinheit (4) für einen Leckluftstrom zwischen dem Kühlluftkanal (5) und dem Abluftkanal (8) ausgebildet ist und drehzahlregelbare Ventilatoren (12) im Abluftkanal (8) angeordnet sind und neben den Lüftern (13) in den elektronischen Moduleinheiten (4) die Luft in einem geschlossenen Kreislauf führen, insbesondere zur Durchführung des Verfahrens nach einem der Ansprüche 1 bis 8,
**dadurch gekennzeichnet,**
**dass** ein Temperatursensor (10) im Bereich des Leckluftstroms angeordnet ist und dass die Temperatur T_{L} des Leckluftstroms, welche durch die Strömungsrichtung des Leckluftstroms und damit von dem zur Verfügung gestellten Luftvolumenstrom im Kühlluftkanal (5) bestimmt wird, die Führungsgröße für die Drehzahlregelung der Ventilatoren (12) ist, wobei bei einer Temperaturerhöhung des Leckluftstroms die Drehzahl der Ventilatoren (12) erhöht und bei einem Temperaturabfall des Leckluftstroms die Drehzahl der Ventilatoren (12) verringert und damit der Volumenstrom der Kühlluft (6) an den von den Moduleinheiten (4) tatsächlich benötigten Volumenstrom angepasst wird.

## Claims

1. Method for regulating the cooling air in equipment cabinets of computer rooms, wherein cooling air (6) is fed to electronic module units (4) arranged in the equipment cabinets (2) and exhaust air (9) impacted with the heat loss of the electronic module units (4) is cooled in an air-fluid heat exchanger (7), wherein the cooling air (6) is fed to the electronic module units (4) by means of front side openings via a cooling air channel (5), which is arranged on the front side, with the aid of fans (12) in an exhaust air channel (8), which is arranged on the rear side, and the heated exhaust air (9) is fed to the exhaust air channel (8) by means of rear side air outlet openings of the electronic module units (4) and subsequently is fed to the air-fluid heat exchanger (7) arranged on the bottom side, and wherein the heat loss is taken up by a cooling fluid and emitted outside of the computer room, and wherein for the air-related separation of the cooling air (6) from the exhaust air (9) separating walls (11, 17) are arranged in the region of the cooling air channel (5), and a leakage air flow is guided through a purposefully incorporated opening (15) in an upper separating wall (17) above the uppermost electronic module unit (4) and between the cooling air channel (5) and the exhaust air channel (8), and wherein the required cooling air quantity of the closed cooling air circuit is conveyed via the rotation speed regulation of the fans (12) in the exhaust air channel (8),
**characterised in that**
the required cooling air quantity is adapted to the volume flow conveyed by ventilators (13) in the electronic module units (4) and that a temperature sensor (10) is arranged in the purposefully incorporated opening (15) in the upper separating wall (17) and that the temperature T_{L} of the leakage air flow which is determined by the flow direction of the leakage air flow and thus by the air volume flow made available in the cooling air channel (5), is measured and used as reference variable for the rotation speed regulation of the fans (12) in the exhaust air channel (8), wherein in the case of a temperature increase of the leakage air flow the rotation speed of the fans (12) is increased and in the case of a temperature drop the rotation speed of the fans (12) is reduced and thus the volume flow of the cooling air (6) is adapted to the volume flow actually required by the module units (4).

2. Method according to claim 1,
**characterised in that**
the purposefully incorporated opening (15) is dimensioned for a leakage air flow between the cooling air channel (5) and the exhaust air channel (8) in such a way that an air quantity which has accumulated above the uppermost electronic module unit (4) in the cooling air channel (5), in particular a hot air pool arising by transfer of heat loss via the metal housings to the cooling air in the cooling air channel (5), is avoided or continuously carried away.

3. Method according to claim 1 or 2,
**characterised in that**
the through-flow quantity and / or the supply temperature of the cooling fluid of the air-fluid heat exchanger (7) is regulated using the temperature sensor (10) in the purposefully incorporated opening (15).

4. Method according to claim 1 or 2,
**characterised in that**
using a second temperature sensor (20) which is arranged in the cooling air channel (5) close to the air-fluid heat exchanger (7) the temperature in the cooling air (6) is measured and used to regulate the through-flow quantity and / or the supply temperature of the air-fluid heat exchanger (7).

5. Method according to claim 4,
**characterised in that**
the temperature reference value of the temperature sensor (10) in the leakage air flow for the rotation speed regulation of the fans (12) is set to be higher in the region of the exhaust air channel (8) than the temperature reference value of the second temperature sensor (20) close to the air-fluid heat exchanger (7) for the regulation of the through-flow quantity and / or supply temperature of the cooling fluid of the air-fluid heat exchanger (7).

6. Method according to one of the claims 1 to 5,
**characterised in that**
the leakage air flow is conveyed in a pipe or in a tube which is arranged between the cooling air channel (5) and the exhaust air channel (8).

7. Method according to one of the claims 1 to 6,
**characterised in that**
more than one leakage air flow is formed in an equipment cabinet (2) and a respective temperature sensor is arranged in the opening (15) or in the pipe or in the tube for the leakage air flow.

8. Method according to one of the claims 1 to 7,
**characterised in that**
the leakage air flows are formed in dependence upon the occupancy of the equipment cabinet (2) with electronic module units (4) and the heat loss thereof and are provided with temperature sensors for regulating the fans (12).

9. Equipment cabinet with a sensor arrangement for regulating the cooling air in the equipment cabinet which is arranged in computer rooms and which comprises a receiving area (3) for electronic module units (4), in particular high power servers, a cooling air channel (5) arranged on the front side for feeling cooling air (6) from an air-fluid heat exchanger (7) arranged on the bottom side, to the electronic module units (4) and an exhaust air channel (8) arranged on the rear side, from which the exhaust air (9) of the electronic module units (4) impacted with the heat loss can be fed to the air-fluid heat exchanger (7), wherein the cooling air channel (5) is separated in terms of air from the exhaust air channel (8) by separating walls (11, 17), an opening (15) is formed in an upper separating wall (17) above the uppermost electronic module unit (4) for a leakage air flow between the cooling air channel (5) and the exhaust air channel (8) and rotation-speed regulatable fans (12) are arranged in the exhaust air channel (8) and which beside the ventilators (13) in the electronic module units (4) convey the air in a closed circuit, in particular for carrying out the method according to one of the claims 1 to 8, **characterised in that**
a temperature sensor (10) is arranged in the region of the leakage air flow and the temperature T_{L} of the leakage air flow which is determined by the flow direction of the leakage air flow and thus by the air volume made available in the cooling air channel (5), is the reference variable for regulating the rotation speed of the fans (12), wherein in the case of a temperature increase of the leakage air flow the rotation speed of the fans (12) is increased and in the case of a drop in temperature of the leakage air flow the rotation speed of the fans (12) is reduced and thus the volume flow of the cooling air (6) is adapted to the volume flow actually required by the module units (4).

## Revendications

1. Procédé de régulation de l'air de refroidissement dans des armoires pour appareils de salles informatiques,
dans lequel de l'air de refroidissement (6) est apporté à des unités modulaires électroniques (4) placées dans les armoires (2) pour appareils et de l'air de sortie (9) chargé avec la chaleur de perte des unités modulaires électroniques (4) est refroidi dans un échangeur (7) de chaleur air-fluide, dans lequel l'air de refroidissement (6) est introduit par un canal (5) d'air de refroidissement placé devant, à l'aide de ventilateurs (12) situés dans un canal (8) d'air de sortie placé derrière, jusqu'aux unités modulaires électroniques (4) par des ouvertures frontales et l'air de sortie réchauffé (9) est introduit, par des ouvertures arrière de sortie d'air des unités modulaires électroniques (4), dans le canal (8) d'air de sortie puis dans l'échangeur (7) de chaleur air-fluide placé au niveau du fond, dans lequel la chaleur de perte est captée par un fluide réfrigérant et délivrée à l'extérieur de la salle informatique, et dans lequel, pour la séparation technique entre l'air de refroidissement (6) et l'air de sortie (9), des cloisons (11, 17) sont placées au niveau du canal (5) d'air de refroidissement et un flux d'air de fuite est envoyé à travers une ouverture (15) prévue spécialement dans une cloison supérieure (17) au-dessus de l'unité modulaire électronique supérieure (4) et entre le canal (5) d'air de refroidissement et le canal (8) d'air de sortie, et dans lequel la quantité nécessaire d'air de refroidissement du circuit fermé d'air de refroidissement est transformée par l'intermédiaire de la régulation de vitesse de rotation des ventilateurs (12) situés dans le canal (8) d'air de sortie,
***caractérisé***
***en ce que*** la quantité nécessaire d'air de refroidissement est adaptée au débit volumique transporté par des soufflantes (13) dans les unités modulaires électroniques (4), et
*en ce qu*'un capteur (10) de température est placé dans l'ouverture (15) prévue spécialement dans la cloison supérieure (17) et la température T_{L} du courant d'air de fuite, qui est déterminée par la direction d'écoulement du courant d'air de fuite et, ainsi, par le débit volumique d'air mis à disposition dans le canal (5) d'air de refroidissement, est mesurée et utilisée comme grandeur principale pour la régulation de vitesse de rotation des ventilateurs (12) dans le canal (8) d'air de sortie, dans lequel, en cas d'élévation de température du courant d'air de fuite, la vitesse de rotation des ventilateurs (12) est augmentée et, en cas de baisse de température du courant d'air de fuite, la vitesse de rotation des ventilateurs (12) est diminuée, et, ainsi, le débit volumique de l'air de refroidissement (6) est adapté au débit volumique réellement nécessaire pour les unités modulaires (4).

2. Procédé selon la revendication 1,
***caractérisé en ce que*** l'ouverture (15) prévue spécialement pour un courant d'air de fuite entre le canal (5) d'air de refroidissement et le canal (8) d'air de sortie est dimensionnée de telle façon qu'une quantité d'air accumulée dans le canal (5) d'air de refroidissement au-dessus de l'unité modulaire électronique (4) supérieure, en particulier une nappe d'air chaud résultant du transfert de chaleur de perte vers l'air de refroidissement présent dans le canal (5) d'air de refroidissement par l'intermédiaire du boîtier métallique, est évitée ou évacuée de manière continue.

3. Procédé selon la revendication 1 ou 2,
***caractérisé en ce que**,* à l'aide du capteur (10) de température présent dans l'ouverture (15) prévue spécialement, le débit et/ou la température d'arrivée du fluide de refroidissement de l'échangeur (7) de chaleur air-fluide est régulé(e).

4. Procédé selon la revendication 1 ou 2,
***caractérisé en ce que**,* à l'aide d'un deuxième capteur (20) de température qui est placé dans le canal (5) d'air frais près de l'échangeur (7) de chaleur air-fluide, la température de l'air de refroidissement (6) est mesurée et utilisée pour réguler le débit et/ou la température d'entrée d'air de l'échangeur (7) de chaleur air-fluide.

5. Procédé selon la revendication 4,
***caractérisé en ce que*** la valeur de consigne de température du capteur (10) de température dans le courant d'air de fuite pour la régulation de vitesse de rotation des ventilateurs (12) est réglée, au niveau du canal (8) de sortie d'air, plus haut que la valeur de consigne de température du deuxième capteur (20) de température près de l'échangeur (7) de chaleur air-fluide pour la régulation du débit et/ou de la température d'entrée du fluide de refroidissement de l'échangeur (7) de chaleur air-fluide.

6. Procédé selon l'une quelconque des revendications 1 à 5,
***caractérisé en ce que*** le courant d'air de fuite est envoyé dans un tube ou un tuyau qui est placé entre le canal d'air de refroidissement (5) et le canal d'air de sortie (8).

7. Procédé selon l'une quelconque des revendications 1 à 6,
***caractérisé en ce que**,* dans une armoire (2) pour appareils, plus d'un courant d'air de fuite est instauré et à chaque fois un capteur de température est placé dans l'ouverture (15) ou dans le tube ou dans le tuyau destiné au courant d'air de fuite.

8. Procédé selon l'une quelconque des revendications 1 à 7,
***caractérisé en ce que*** les courants d'air de fuite sont instaurés en fonction de l'occupation de l'armoire (2) pour appareils par des unités modulaires électroniques (4) et de leur chaleur de perte, et sont munis de capteurs de température pour la régulation des ventilateurs (12).

9. Armoire pour appareils avec un dispositif de capteur pour réguler l'air de refroidissement dans l'armoire pour appareils, qui est placée dans des salles informatiques et comprend un logement (3) pour des unités modulaires électroniques (4), en particulier des serveurs à hautes performances, un canal (5) d'air de refroidissement placé devant pour apporter de l'air de refroidissement (6) aux unités modulaires électroniques (4) depuis un échangeur (7) de chaleur air-fluide placé au niveau du fond
et un canal (8) de sortie d'air placé derrière, depuis lequel l'air de sortie (9) chargé avec la chaleur de perte des unités modulaires électroniques (4) peut être envoyé à l'échangeur (7) de chaleur air-fluide, dans lequel le canal (5) d'air de refroidissement est séparé, en termes de techniques d'air, du canal (8) de sortie d'air par des cloisons (11, 17), une ouverture (15) est formée dans une cloison supérieure (17) au-dessus de l'unité modulaire électronique (4) supérieure pour un courant d'air de fuite entre le canal (5) d'air de refroidissement et le canal (8) d'air de sortie, et des ventilateurs (12) à vitesse de rotation réglable sont placés dans le canal de sortie d'air (8) et, à côté de soufflantes (13) dans les unités modulaires électroniques (4), ils transportent l'air dans un circuit fermé, en particulier pour appliquer le procédé selon l'une quelconque des revendications 1 à 8,
*caractérisé*
*en ce qu*'un capteur (10) de température est placé au niveau du courant d'air de fuite et
*en ce que* la température T_{L} du courant d'air de fuite, qui est déterminée par la direction découlement du courant d'air de fuite et, ainsi, par le débit volumique d'air mis à disposition dans le canal (5) d'air de refroidissement, constitue la grandeur principale pour la régulation de vitesse de rotation des ventilateurs (12), dans lequel, en cas d'élévation de température du courant d'air de fuite, la vitesse de rotation des ventilateurs (12) est augmentée et, en cas de baisse de température du courant d'air de fuite, la vitesse de rotation des ventilateurs (12) est diminuée, et, ainsi, le débit volumique de l'air de refroidissement (6) est adapté au débit volumique réellement nécessaire pour les unités modulaires (4).
